# EUROPÄISCHE PATENTANMELDUNG

(11) **EP 3 016 284 A1**
(43) Veröffentlichungstag der Anmeldung: **04.05.2016**
(21) Anmeldenummer: 15181812.7
(22) Anmeldetag: 20.08.2015
(51) Int. Cl.: H03K 17/95

(54) **INDUKTIVER NÄHERUNGSSCHALTER UND VERFAHREN FÜR DEN BETRIEB DESSEN**

(30) Priorität: 31.10.2014 DE 102014016217
(71) Anmelder: wenglor sensoric elektronische Geräte GmbH, 88069 Tettnang (DE)
(72) Erfinder: Dräger, Andreas, 88046 Friedrichshafen (DE)
(74) Vertreter: Engelhardt & Engelhardt

(57) **Zusammenfassung**

Bei einem induktiver Näherungsschalter (1) zur Erfassung eines Gegenstandes (2) in einem Überwachungsbereich (20), der aus mindestens einem elektrischen Schaltkreis (5) aufweist, der in einem Gehäuse (3) an einem Traggestell (21) befestigbar angeordnet ist, bestehend aus
- einem Schwingkreis (6, 11) mit einer Parallelschaltung aus einer Sensorspule (7) und einem Kondensator (8),
- aus einer Oszillatorschaltung (9), durch den der Schwingkreis (6, 11) in seiner Resonanzfrequenz (f₁) betrieben ist und
- aus einer nachgeschalteten Auswerteeinheit (26), durch die ein Schaltsignal bei der Annäherung des Gegenstandes (2) generiert ist,
soll der Schaltabstand (sᵣ) unabhängig von der Einbausituation und den magnetischen Eigenschaften des Traggestells (21) einstellbar seien.

Diese Aufgabe ist dadurch gelöst, dass beabstandet zu dem ersten Schwingkreis (6) ein zweiter Schwingkreis (11) vorgesehen ist, dass der zweite Schwingkreis (11) durch eine zweite Oszillatorschaltung (9) in seiner Resonanzfrequenz (f₂) betrieben ist, dass zwischen dem ersten und dem zweiten Schwingkreis (6, 11) eine Abschirmschicht (12) angeordnet ist.

## Beschreibung

Die Erfindung bezieht sich auf einen induktiver Näherungsschalter zur Erfassung eines Gegenstandes in einem Überwachungsbereich, nach dem Oberbegriff des Patentanspruches 1 sowie auf ein Verfahren für den Betrieb des induktiven Näherungsschalters nach dem Oberbegriff des Patentanspruches 10.

Derartige induktive Näherungsschalter sind im industriellen Einsatz vielseitig bewährt und dienen zur Erfassung des Abstandes von metallischen Gegenständen. Der induktive Näherungsschalter ist hierzu zur Befestigung an einem Traggestell befestigt und in einen Überwachungsbereich gerichtet. In der Literatur werden diese induktiven Näherungsschalter auch schweißfeste induktive Allmetallsensoren oder Allmetallschalter genannt.

Ein derartiger Sensor ist beispielsweise aus der DE 102 44 104 B4 zu entnehmen. Üblicherweise umfassen solche Näherungsschalter bzw. deren elektrische Schaltkreise eine von Wechselstrom durchflossene Sendespule und zwei Empfangsspulen, deren Schaltung auch Differenzial- Transformator-Schaltung genannt ist. Ein durch die Sendespule gebildetes Magnetfeld induziert eine Spannung in die Empfangsspulen. Nähert sich ein metallischer Gegenstand dieser Schaltung an, so ist eine Spannungsänderung in den Empfangsspulen messbar.

Nachteiliger Weise sind derartige Sensoren anfällig auf Temperaturschwankungen und zeigen ein instabiles Langzeitschaltverhalten. Temperaturänderungen und Materialalterung beispielsweise der Vergussmasse, verändern nämlich lokal die magnetischen Feldlinien und führen somit zu einem veränderten Schaltabstand oder sogar zum ungewollten Schaltverhalten.

Eine weitere Ausführungsvariante des induktiven Näherungsschalters bzw. dessen elektrischen Schaltkreises ist mit einem LC-Schwingkreis ausgeführt, der mit einer vorgegebenen Frequenz betrieben ist. Ein derartig ausgeführter induktiver Näherungsschalter ist aus der DE 3912946 C3 bekannt. Sobald sich ein metallischer Gegenstand dem LC-Schwingkreis nähert, ist dem Schwingkreis Energie entzogen und die Amplitude sowie die Frequenz des Schwingkreises sind verändert. Diese Änderungen sind durch eine geeignete Auswerteeinheit erfasst und ein Schaltsignal ist generiert.

Technisch bedingt üben die sich nähernden Objekte oder Gegenstände aus andersartigen metallischen Werkstoffen auf den Schwingkreis unterschiedliche Einflüsse aus, und zwar in Abhängigkeit von den magnetischen Eigenschaften des Werkstoffes. Nachteiliger Weise ist folglich der Schaltabstand für unterschiedliche Werkstoffe in Abhängigkeit von den magnetischen oder nichtmagnetischen Eigenschaften einzustellen. Somit ist für jede Einbausituation des induktiven Näherungsschalters eine Voreinstellung zu treffen, um die Werkstoffeigenschaften des Traggestelles zu berücksichtigen. Solche Voreinstellungen sind technisch kompliziert und zeitintensiv.

Aus der DE 10 2005 045 711 B4 ist ein induktiver Sensor bekannt, der mittels eines LC-Schaltkreises Stangen oder Rohre aus unterschiedlichen Materialien und unterschiedlicher Durchmessern erkennt. Bei dem Durchführen von Rohren oder Stangen durch die Ringspule des induktiven Sensors verändern sich die Amplitude und die Frequenz des Schwingkreises. Anhand der Messwertpaarung der Amplitude und der Frequenz sind die Materialeigenschaften und die geometrischen Dimensionen durch einen Vergleich mit einer zuvor hinterlegten Datenmenge möglich.

Nachteilig bei diesem Stand der Technik ist die zwingende Vorkenntnis der Einbausituation und der magnetischen Eigenschaften des Traggestells. Dies führt nämlich dazu, dass der Schaltabstand nicht unabhängig von der Einbausituation einstellbar ist, bzw. dass der Schaltabstand in unterschiedlichen Einbausituationen variiert.

Ferner sind derartige Sensoren auf äußere magnetische Wechselfelder störanfällig. Ein äußeres magnetisches Wechselfeld induziert Wechselspannungen in die Sensorspule. Dies führt zu einem ungewünschten Schaltverhalten, so dass das Einsatzspektrum eines derart störanfälligen Sensors begrenzt ist. Auch statische magnetische Felder beeinflussen das Schaltverhalten derartiger induktiver Näherungsschalter, so dass abhängig von der Einbausituation des induktiven Näherungsschalters der Schaltabstand variiert.

Es ist daher Aufgabe der Erfindung, einen induktiven Näherungsschalter und ein Verfahren zum Betrieb dessen der eingangs genannten Gattung zur Verfügung zu stellen, bei dem unabhängig von der Einbausituation und den magnetischen Eigenschaften des Traggestells ein konstanter Schaltabstand einstellbar ist.

Diese Aufgabe ist erfindungsgemäß durch die Merkmale der kennzeichnenden Teile der Patentansprüche 1 und 10 gelöst.

Weitere vorteilhafte Weiterbildungen der Erfindung ergeben sich aus den Unteransprüchen.

Dadurch, dass beabstandet zu dem ersten Schwingkreis ein zweiter Schwingkreis vorgesehen ist, dass der zweite Schwingkreis durch eine zweite Oszillatorschaltung in einer Resonanzfrequenz betrieben ist und dass zwischen dem ersten und dem zweiten Schwingkreis eine Abschirmschicht angeordnet ist, kann ein Schaltsignal bei der Annäherung eines magnetischen oder nichtmagnetischen metallischen Gegenstandes völlig unabhängig von der Einbausituation und den magnetischen Werkstoffeigenschaften des Traggestells bei konstantem Schaltabstand generiert sein, da durch die zwei Schwingkreise eine Kompensation der Einflüsse des Traggestelles ermöglicht ist.

Die beiden Schwingkreise, die durch ihre jeweilige Oszillatorschaltung in der Resonanzfrequenz zum Schwingen angeregt sind, werden durch die Annäherung eines metallischen Objektes und des Traggestells unterschiedlich beeinflusst. Bei der Annäherung eines metallischen Gegenstandes ist die Resonanzfrequenzänderung des ersten Schwingkreises höher als die Resonanzfrequenzänderung des zweiten Schwingkreises aufgrund der zwischen der ersten und dem zweiten Schwingkreis angeordneten Abschirmschicht. Der erste Schwingkreis ist dabei an der dem Überwachungsbereich zugewandten Seite des Gehäuses angeordnet und der zweite Schwingkreis parallel und beabstandet in einer Ebene zu dem ersten Schwingkreis in dem Gehäuse auf der dem Überwachungsbereich abgewandten Seite. Zwischen dem zweiten Schwingkreis und der dem Traggestell zugewandten Seite des Gehäuses kann eine zweite Abschirmschicht vorgesehen sein, so dass der Schaltabstand unabhängig von den Umgebungsbedingungen des induktiven Näherungsschalters eingestellt sein kann. Demnach kann der induktive Näherungsschalter auf metallischen, magnetischen bzw. metallisch nichtmagnetischen Traggestellen angeordnet bzw. befestigt sein, ohne dass der Schaltabstand verändert ist.

Darüber hinaus ist es besonders vorteilhaft, dass den beiden Schwingkreisen ein Referenzoszillator zugeordnet ist und dass eine Frequenzänderung des jeweiligen Schaltkreises durch einen nachgeschalteten Mischer ermittelbar ist.

Ein Komparator kann den Mischern nachgeschaltet sein, so dass der Komparator in Abhängigkeit von der Frequenzänderungen der beiden Schwingkreise ein Schaltsignal generiert. Durch den erfindungsgemäßen induktiven Näherungsschalter kann vorteilhafterweise der Schaltabstand unabhängig von den magnetischen Eigenschaften des metallischen Gegenstandes eingestellt werden. Durch das Auswerten der Resonanzfrequenzänderungen mittels der jeweiligen Referenzoszillatoren ist auch die Erfassung großer Schaltabstände möglich, da auch kleine Resonanzfrequenzänderungen erfassbar sind. Dies kann weiterhin vorteilhaft begünstigt sein, wenn die Frequenz des Referenzoszillators bis zu 10 Prozent niedriger ist als die Resonanzfrequenz des Schwingkreises.

In der Zeichnung ist ein erfindungsgemäßes Ausführungsbeispiel eines induktiven Näherungsschalters dargestellt, das nachfolgend näher erläutert ist. Im Einzelnen zeigt
- Figur 1: einen induktiven Näherungsschalter, dessen Gehäuse eine flache rechteckige Bauform aufweist,
- Figur 2: ein schematisches Schaltbild eines elektrischen Schaltkreises, durch den der induktiver Näherungsschalter gemäß Figur 1 gebildet ist, mit einem ersten und einem zweiten Schwingkreis, die jeweils durch eine Oszillatorschaltung in der Resonanzfrequenz betrieben sind,
- Figur 3a: ein Signalverlaufsdiagramm der beiden Schwingkreise gemäß Figur 2 bei der Annäherung eines magnetischen Gegenstandes und
- Figur 3b: ein Signalverlaufsdiagramm der Schwingkreise gemäß Figur 2 bei einer unterschiedlichen Einbausituation auf einem metallischen Untergrund.

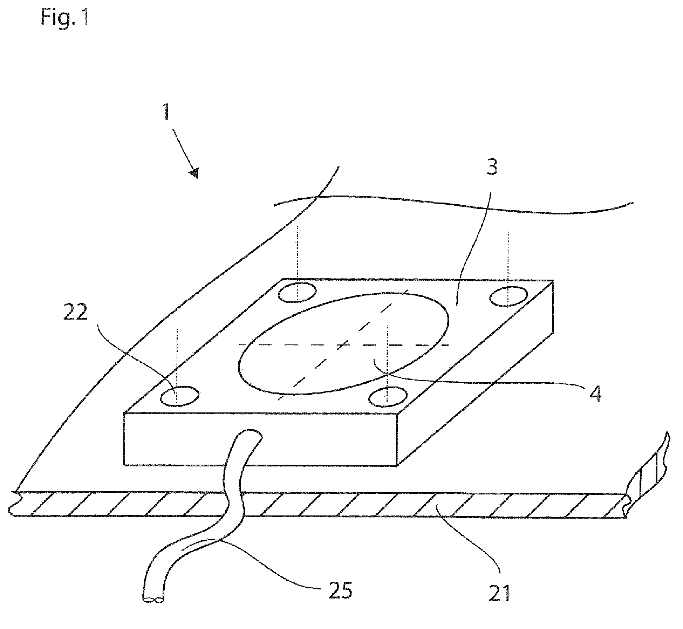

Der Figur 1 ist ein induktiver Näherungsschalter 1 zur Erfassung von metallischen Gegenständen 2 in einem Überwachungsbereich 20 zu entnehmen, der in einem Gehäuse 3 angeordnet ist. Der induktive Näherungsschalter 1 ist mittels Befestigungsschrauben 22 an einem Traggestellt 21 befestigt und auf den Überwachungsbereich 20 ausgerichtet. In das Gehäuse 3 ist auf der dem Überwachungsbereich 20 zugewandten Seite eine Sensorabdeckungskappe 4 eingearbeitet unter der in dem Gehäuse 3 ein elektrischer Schaltkreis 5 angeordnet ist.

Die Sensorabdeckungskappe 4 besteht aus einem nicht leitenden, nicht magnetischen Material, so dass in dem groß bemessenen Überwachungsbereich 20 der Gegenstand 2 erfassbar ist. Der induktive Näherungsschalter 1 ist mittels elektrischer Leitungen 25 mit einer geeigneten Auswerte- oder Schaltelektronik verbunden, durch die der induktive Näherungsschalter 1 gleichzeitig mit einer benötigten elektrischen Spannung versorgt wird.

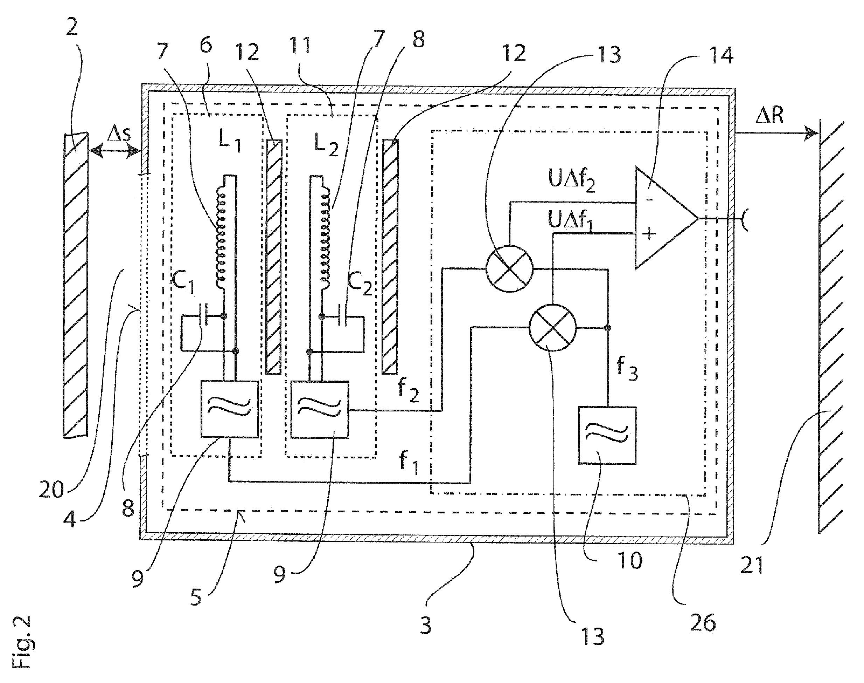

Der Figur 2 ist eine schematische Darstellung des elektrischen Schaltkreises 5 ? des induktiven Näherungsschalters 1, durch den die Annäherung des metallischen Gegenstandes 2 erfassbar ist, zu entnehmen. Der Gegenstand 2 kann teilweise oder vollständig metallisch sein.

Der elektrische Schaltkreis 5 des induktiven Näherungsschalters 1, besteht aus einem ersten Schwingkreis 6 und einem zweiten Schwingkreis 11. Die Schwingkreise 6, 11 sind durch eine Parallelschaltung einer Sensorspule 7 mit einem Kondensator 8 gebildet und werden durch eine Oszillatorschaltung 9 in Schwingung versetzt. Der jeweilige elektrische Schwingkreis 6, 11 schwingt demnach in seiner Resonanzfrequenz f₁, f₂. Die Frequenzen f₁, f₂ in den die Schwingkreise 6, 11 durch die jeweilige Oszillatorschaltung 9 betrieben sind können unterschiedlich hoch bemessen sein.

Der erste und der zweite Schwingkreis 6, 11 sind jeweils in einer Ebene parallel und beabstandet zueinander angeordnet. Der erste Schwingkreis 6 ist dabei auf der dem Überwachungsbereich 20 zugewandten Seite des Gehäuse 3 parallel und beabstandet unterhalb der Sensorabdeckungskappe 4 angeordnet.

Zwischen dem ersten Schwingkreis 6 und dem zweiten Schwingkreis 11 ist eine erste Abschirmschicht 12 angeordnet. Eine zweite Abschirmschicht 12 ist darüber hinaus zwischen dem zweiten Schwingkreis 11 und der dem Traggestell 21 zugewandten Seite des Gehäuses 3 vorgesehen. Die Abschirmschichten 12 sind vorzugsweise aus einem metallischen und nicht magnetischen Werkstoff gebildet, vorzugsweise Kupfer.

Dem jeweiligen Schwingkreis 6, 11 ist ein Mischer 13 nachgeschaltet, der mit einem Referenzoszillator 10 verbunden ist. Der Referenzoszillator 10 ist als quarzstabiler Oszillator ausgebildet. Der Mischer 13 bildet aus den Frequenzen f₁, f₂ der Schwingkreise 6, 11 jeweils eine Mischfrequenz, die der Frequenzänderung des jeweiligen Schwingkreises 6, 11 entspricht. Die Mischfrequenzen Δf₁, Δf₂ sind in eine proportionale Spannung uΔf₁, uAf₂ gewandelt.

Ein Komparator 14 wertet differenziell die beiden Spannungen uΔf₁ und uΔf₂ der beiden Mischer 13 aus und gibt bei der Annäherung eines metallischen Gegenstandes 2 ein Schaltsignal aus.

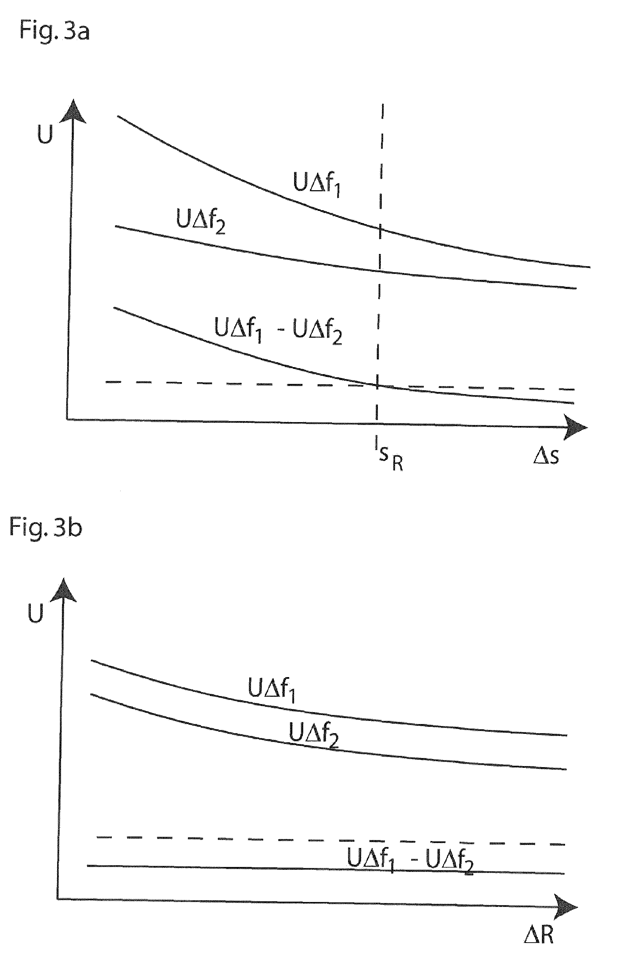

In der Figur 3a sind die Spannungsverläufe uΔf₁ und uΔf₂, die proportional zu der Resonanzfrequenzänderung Δf₁, Δf₂ der beiden Schwingkreise 6, 11 sind über die Entfernung Δs des Gegenstandes 2 aufgetragen. Den Kurvenverläufen ist zu entnehmen, dass bei der Annäherung des metallischen Gegenstandes die Resonanzfrequenz f₁, f₂ der beiden Schwingkreise 6, 11 bzw. die Resonanzfrequenzänderung Δf₁, Δf₂ und deren dazu proportionale Spannung uΔf₁, uAf₂ ansteigen. Aufgrund der Abschirmschicht 12 zwischen dem ersten Schwingkreis 6 und dem zweiten Schwingkreis 11 ist die Resonanzfrequenzänderung Δf₂ geringer fügiger als die Resonanzfrequenzänderung Δf₁. Der Komparator 14 vergleicht die Spannungen der Resonanzfrequenzänderungen uΔf1 und uΔf₂, und überschreiten die beiden differenziell ausgewerteten Spannungen uΔf₁ und uΔf₂, einen vorgegebenen Wert, so schaltet der induktive Näherungsschalter 1 ein. Der Abstand Δs des metallischen Gegenstandes entspricht dem Schaltabstand sᵣ.

An dem Komparator 14 kann eine Referenzspannung angelegt sein, durch die der Anwender den Schaltabstand sᵣ einstellen kann.

In Figur 3b sind die Signalverläufe der Resonanzfrequenzänderungen Δf₁ und Δf₂ bzw. der dazu proportionalen Spannungen uΔf₁ und uAf₂ der beiden Schwingkreise 6, 11 zu entnehmen. Die Spannungen uΔf₁ und uAf₂ sind in Abhängigkeit von dem Abstand ΔR bzw. der magnetischen Eigenschaften des Traggestells 21 aufgetragen. Das Traggestell 21 kann aus einem beliebigen Werkstoff hergestellt sein, so dass die Resonanzfrequenz f₁, f₂ der Schwingkreise 6, 11 durch das Traggestell 21 beeinflusst sind. Aufgrund der zweiten Abschirmschicht 12 zwischen dem zweiten Schwingkreis und der dem Traggestell 21 zugewandten Seite des Gehäuses 3 nehmen uΔf₁ und uAf₂ bei einer Annäherung des metallischen Traggestells 21 leicht zu. Aufgrund der differenziellen Auswertung in dem Komparator 14 bleibt jedoch die Spannungsdifferenz uΔf₁ - uAf₂ konstant. Die voreingestellte Schaltschwelle bzw. Schaltspannung uᵣ ist nicht überschritten, so dass der induktive Näherungsschalter 1 nicht schaltet und der eingestellte Schaltabstand sᵣ konstant bleibt.

Die Sensorspule 6, die erste Abschirmschicht 12, die zweite Sensorspule 7 und die zweite Abschirmschicht 12 werden vorzugsweise als Leiterplattenspule bzw. Planarspule parallel und beabstandet in einer Achse ausgebildet. Die Auswerteeinheit 26 kann dabei mit auf der Leiterplatte zwischen der zweiten Abschirmschicht 12 und der dem Gestell 21 zugewandten Seite des Gehäuses 3 angeordnet sein. Die zweite Abschirmschicht 12 kann gleichzeitig auch als Massefläche für die elektronische Schaltung fungieren. Somit ist es möglich, die Sendespulen 7 größtmöglich auszugestalten, um eine größtmögliche Reichweite des Überwachungsbereiches 20 zu erzielen und gleichzeitig eine kleine Bauform des Gehäuses 3 zu gewährleisten.

Die Form der Spulen ist beliebig wählbar. Es können quadratische, rechteckige, ringförmige oder vieleckige Formen gewählt werden, die an die Außengeometrie des Gehäuses 3 angepasst sind. Darüber hinaus kann die Abschirmschicht 12 an die Geometrie der Sensorspule 7 angepasst sein und die Sensorspule 7 teilweise oder ganz umgreifen.

## Patentansprüche

1. Induktiver Näherungsschalter (1) zur Erfassung eines Gegenstandes (2) in einem Überwachungsbereich (20), der aus mindestens einem elektrischen Schaltkreis (5) aufweist, der in einem Gehäuse (3) an einem Traggestell (21) befestigbar angeordnet ist, bestehend aus
- einem Schwingkreis (6, 11) mit einer Parallelschaltung aus einer Sensorspule (7) und einem Kondensator (8),
- aus einer Oszillatorschaltung (9), durch den der Schwingkreis (6, 11) in seiner Resonanzfrequenz (f₁) betrieben ist und
- aus einer nachgeschalteten Auswerteeinheit (26), durch die ein Schaltsignal bei der Annäherung des Gegenstandes (2) generiert ist,
**dadurch gekennzeichnet,**
**dass** beabstandet zu dem ersten Schwingkreis (6) ein zweiter Schwingkreis (11) vorgesehen ist, dass der zweite Schwingkreis (11) durch eine zweite Oszillatorschaltung (9) in seiner Resonanzfrequenz (f₂) betrieben ist, dass zwischen dem ersten und dem zweiten Schwingkreis (6, 11) eine Abschirmschicht (12) angeordnet ist

2. Induktiver Näherungsschalter (1) nach Anspruch 1,
**dadurch gekennzeichnet,**
**dass** der erste Schwingkreis (6) in dem Gehäuse (3) an der dem Überwachungsbereich (20) zugewandten Seite angeordnet ist, dass der zweite Schwingkreis (11) in einer Ebene parallel und beabstandet zu der Ebene des ersten Schwingkreis (6) im Gehäuse (3) an der dem Überwachungsbereich (20) abgewandten Seite angeordnet ist.

3. Induktiver Näherungsschalter (1) nach Anspruch 1 oder 2,
**dadurch gekennzeichn**
dass zwischen dem zweiten Schwingkreis (11) und der dem Traggestell (21) zugewandten Seite des Gehäuses (3) eine zweite Abschirmschicht (12) vorgesehen ist.

4. Induktiver Näherungsschalter (1) nach einen der vorgenannten Ansprüche,
**dadurch gekennzeichn**
dass jedem Schwingkreis (6, 11) ein Referenzoszillator (10) zugeordnet ist und dass eine Frequenz-Änderung (Δ_{f}) des jeweiligen Schwingkreises (6, 11) durch jeweils einen nachgeordneten Mischer (13) ermittelbar ist.

5. Induktiver Näherungsschalter (1) nach Anspruch 4,
**dadurch gekennzeichnet,**
**dass** ein Komparator (14) den Mischern (13) nachgeschaltet ist, und dass der Komparator (14) in Abhängigkeit von den Frequenz-Änderungen (Δf₁, Δf₂) der Schwingkreise (6, 11) ein Schaltsignal auswertbares generiert.

6. Induktiver Näherungsschalter (1) nach Anspruch 4,
**dadurch gekennzeichnet,**
**dass** der Referenzoszillator (10) als quarzstabiler Oszillator ausgestaltet ist und dass der Referenzoszillator (10) mit einer geringfügig höheren Frequenz (f₃) angeregt ist als die der Oszillatorschaltungen (9).

7. Induktiver Näherungsschalter (1) nach Anspruch 4,
**dadurch gekennzeichnet,**
**dass** der Mischer (11), der Referenzoszillator (10) und der Komparator (14) in einem programmierbaren Logikbaustein eingebaut sind und dass die Sendespulen (7) als Planarspulen ohne Ferritkern ausgebildet sind.

8. Induktiver Näherungsschalter (1) nach Anspruch 4,
**dadurch gekennzeichnet,**
**dass** der Referenzoszillator (10) in einer höheren/oder niedrigeren Frequenz (f₃) als die Oszillatorschaltungen (9) betrieben ist.

9. Induktiver Näherungsschalter (1) nach einen der vorgenannten Ansprüche
**dadurch gekennzeichnet,**
**dass** die Abschirmschicht (12) aus einem gut leitfähigen Werkstoff, vorzugsweise ein metallischer Werkstoff, gebildet ist und dass der Abschirmschicht (12) die Sensorspule (7) teileweise oder ganz umgibt.

10. Verfahren für den Betrieb eines induktiven Näherungssensors (1), insbesondere nach einem der vorgenannten Ansprüche, der aus zwei Schwingkreise (6, 11) gebildet ist die jeweils aus einer Sensorspule (7) und einen parallel dazu geschalteten Kondensator (8) bestehen und in der Resonanzfrequenz betrieben sind und einer Auswerteeinheit (26) durch die eine Resonanzfrequenzänderung Schwingkreise erfasst ist,
**gekennzeichnet durch** die nachfolgenden Verfahrensschritte:
- Betrieben des ersten Schwingkreises (6) und eines zweiten Schwingkreises (11) in seiner Resonanzfrequenz **durch** jeweils eine Oszillatorschaltung (9)
- Bestimmen der jeweiligen Resonanzfrequenzänderungen (Δ_{f1}, Δ_{f2}) der Schwingkreise (6, 11) mittels eines Referenzoszillators (10)
- Erzeugen eines Schaltsignales bei der Annäherung eines magnetischen oder nicht magnetischen metallischen Gegenstandes (2) aufgrund der unterschiedlichen Resonanzfrequenzänderungen (Δ_{f1}, Δ_{f2}).

11. Verfahren nach Anspruch 8,
**gekennzeichnet durch**
Bilden der Frequenz-Änderungen (Δ_{f1}, Δ_{f2}) aus den Resonanzfrequenzen (f₁, f₂) der Schwingkreise (4,) und der Referenzfrequenz (f₃) des Referenzoszillators (10).

12. Verfahren nach Anspruch 8 oder 9,
**gekennzeichnet durch**
Erzeugen des Schaltsignals (24) **durch** ein Komparator (14) in Abhängigkeit von den Resonanzfrequenzänderungen (Δ_{f1}, Δ_{f2}).
